# EUROPEAN PATENT APPLICATION

(11) **EP 0 773 710 A1**
(43) Date of publication of application: **14.05.1997**
(21) Application number: 96914395.7
(22) Date of filing: 22.05.1996
(51) Int. Cl.: H05K 3/38, H05K 1/03, H05K 1/09, B32B 15/08

(54) **FLEXIBLE PRINTED WIRING BOARD**

(30) Priority: 26.05.1995 JP 152577/95
(71) Applicant: TOYO METALLIZING CO.,LTD., Tokyo 103 (JP)
(72) Inventor: YAMASHITA, Masayuki, Shizuoka 410-11 (JP); NISHIGAWA, Tadahiro, Mishima Shizuoka 411 (JP); TOHYAMA, Shunroku, Mishima Shizuoka 411 (JP)
(74) Representative: Coleiro, Raymond
(86) International application number: JP9601350
(87) International publication number: WO9638029

(57) **Abstract**

A durable two-layer substrate for flexible printed wiring is disclosed, which is improved in the durability of adhesion after thermal loading subsequent to circuit formation and does not cause delamination between the copper and polyimide layers of the substrate even if it is exposed to a high temperature of about 150°C for a long time of about 10 days after plating, particularly electroless plating.

The substrate for flexible printed wiring of the present invention comprises a polyimide film containing tin by 0.02 to 1 wt% based on the weight of the film; a vapor-deposited metal, being partially or wholly diffused in the depth direction from the surface of the film; a first vapor-deposited metal layer with a thickness of 10 to 300 Å including said diffusion layer, being provided on either or both sides of the film; and a second vapor-deposited copper layer on said first vapor-deposited layer.

## Description

### Technical field

The present invention relates to an adhesive-less two-layer substrate for flexible printed wiring which will contribute to the reduction in size and weight of electronic apparatuses and parts, in more detail, said substrate for flexible printed wiring used for TAB, COF, BGA, etc. in semiconductor packaging.

### Background art

As a conventional substrate for flexible printed wiring, a three-layer substrate, in which a copper foil and an aluminum foil are bonded onto a polyimide film by an adhesive, is known. This substrate has the following problems considered to be attributable to the adhesive used. First of all, since the adhesive is worse than the film in thermal performance, the substrate has such disadvantages that the dimensional accuracy declines and that the electric characteristics are deteriorated by contamination with impurity ions. So, it cannot be used for high density wiring. It also has such disadvantages that the thickness of the adhesive layer gives an increment to the entire size, and that machinability in drilling the through holes on both sides is poor. It can be said that this substrate has many disadvantages for reduction in size and weight.

On the other hand, adhesive-less two-layer substrates for flexible printed wiring, with a metallic layer formed by vacuum evaporation, sputtering, ion plating or copper plating, etc., are proposed.

For example,
(1) Japanese Patent Laid-Open (Kokai) No. 4-329690 proposes a carrier for flexible electric circuit, in which a vapor-deposited chromium based ceramic layer, a vapor-deposited copper or copper alloy layer and a copper plated layer are laminated in this order on an insulating film. It is intended to ensure a higher adhesive strength between the insulating film and the wired copper layer in the circuit board formed by the carrier even if it has been allowed to stand at high temperature and high humidity (85°C and 80% humidity) for 250 hours. However, if a thermal load of a higher temperature, say, about 150°C is applied for about 10 days, the adhesion between the film and the copper layer is not reliable enough. Furthermore, in the case of a carrier found to be highly reliable in the adhesion as a result of said thermal load test, if the carrier with a circuit formed on it is electrolessly plated with tin, and subjected to said thermal load test, it greatly declines in the adhesion.
(2) Japanese Patent Laid-Open (Kokai) No. 6-29634 proposes a material for flexible printed circuit board, in which a thin metallic under layer and a thin copper layer are formed on one side of a polyimide film while a thin film small in oxygen permeability is formed on the other side, further with a copper layer for circuit formed on either or both sides of the laminate. It is intended to ensure a higher adhesive strength between the polyimide film and the wired copper layer in the circuit board formed by the material composed as described above even if it has been allowed to stand in a 150°C oven for 10 days. However, even in the case of a board found to be durable in adhesion as a result of said thermal load test, if the board with a circuit formed on it is electrolessly plated with tin and subjected to said thermal load test, it also greatly declines in adhesion.
(3) Japanese Patent Laid-Open (Kokai) No. 4-290742 proposes a process for preparing a metal-film laminate, comprising the steps of arranging a metal oxide at random on a polymer film and forming a vapor-deposited metal layer and a metal plated layer. The laminate produced by this method is intended to be less likely to cause the delamination between the metal layer and the film in spite of chemical processing (metal plating and etching) and mechanical stresses (cutting, drilling, assembling and soldering) and environmental stresses in ordinary operation conditions. However, the durability of the laminate in adhesion in a thermal load test of about 150°C greatly fluctuates and is poor in reliability. Furthermore, if the laminate with a circuit formed on it is electrolessly plated with tin and subjected to the thermal load test, it greatly fluctuates in adhesion, being very poor in reliability.
(4) Japanese Patent Publication (Kokoku) No. 4-65558 proposes a process for preparing a circuit material, comprising the steps of sputtering a 25 to 150 Å thick chromium/chromium oxide layer on an electrically insulating film, sputtering a less than 1 µm thick copper layer, and coating the copper layer with a photoresist composition. It is intended to achieve a higher accuracy in circuit formation and a higher bonding strength between the wired copper film and the polyimide film by forming a circuit pattern using the material obtained by the process and plating copper on the circuit pattern for lamination. However, even in the case of a substrate found to be durable in adhesion as a result of a thermal load test of 150°C x about 10 days, if the substrate with a circuit formed on it is electrolessly plated with tin and is subjected to said thermal load test, it also greatly declines in adhesion. As described above, in these prior arts, the adhesion between the copper film with a desired circuit formed in it and the polyimide film is not reliable enough in the durability after application of thermal loading. Furthermore, these prior arts are disadvantageously very poor in the durability of adhesion after application of thermal loading especially when electroless plating is used, and this is considered to be caused by the nickel, gold, tin, solder, etc. plated on the circuit for solder wetting, corrosion prevention, bonding, etc. As for the cause, it is considered that the compound used for plating acts anyway to deteriorate the interface between the polyimide film and the vapor-deposited layer. To overcome the decline of adhesive strength, the inventors studied intensively to ensure that the polyimide film, the vapor-deposited layer, their interface and the copper layer on the vapor-deposited layer endure the action of plated compound, particularly electrolessly plated compound and thermal loading.

### Disclosure of the invention

The main object of the present invention is to provide a durable two-layer substrate for flexible printed wiring which is more durable in adhesion after application of thermal loading and does not cause delamination between the copper film and the polyimide film even if the substrate is exposed to a high temperature of about 150°C for a long time of about 10 days after said plating, particularly electroless plating. As a result of a study by the inventors, it was found that the main object of the present invention can be industrially advantageously achieved by the following present invention.
[1] A substrate for flexible printed wiring, comprising a polyimide film containing tin by 0.02 to 1 wt% based on the weight of the film; a vapor-deposited metal, being partially or wholly diffused in the depth direction from the surface of the film; a first vapor-deposited metal layer with a thickness of 10 to 300 Å including said diffusion layer, being provided on either or both sides of the film; and a second vapor-deposited copper layer on said first vapor-deposited layer.
[2] A substrate for flexible printed wiring, according to said [1], wherein a copper plated layer is formed further on the second vapor-deposited layer.
[3] A substrate for flexible printed wiring, according to said [1] or [2], wherein the metal of the first vapor-deposited metal layer is any one or more selected from a group consisting of chromium, chromium alloys and chromium compounds.
[4] A substrate for flexible printed wiring, according to said [1] or [2], wherein the metal of the first vapor-deposited metal layer is nichrome of less than 20% in chromium content.
[5] A substrate for flexible printed wiring, according to said [1] or [2], wherein the metal of the first vapor-deposited metal layer is nickel.
[6] A substrate for flexible printed wiring, according to any one of said [1] through [5], wherein the polyimide has through holes drilled.
[7] A substrate for flexible printed wiring, according to any one of said [1] through [6], wherein the polyimide film has a contact angle with water of 15 to 35°.

That is, the main object of the present invention can be achieved by a substrate for flexible printed wiring, comprising a polyimide film containing tin by 0.02 to 1 wt% based on the weight of the film; a vapor-deposited metal, being partially or wholly diffused in the depth direction from the surface of the film; a first vapor-deposited metal layer with a thickness of 10 to 300 Å including said diffusion layer, being provided on either or both sides of the film; and a second vapor-deposited copper layer on said first vapor-deposited layer.

To further enhance the effect of the present invention, it is preferable to use a polyimide film surface-treated to be 15 to 35° in the contact angle with water.

The substrate for flexible printed wiring of the present invention is excellent in thermal load resistance after electroless plating as well as electroplating. So, the present invention can provide a highly reliable flexible printed circuit board. Therefore, the substrate for flexible printed wiring of the present invention can be applied in every area of electronics, for example, to circuit boards requiring bonding such as TAB, COF and BGA as well as to general flexible printed circuit boards. Furthermore, the substrate for flexible printed wiring of the present invention can also be applied to high density circuit boards in these areas.

### Brief description of the drawings

Figs. 1 through 4 are sectional views showing examples of the substrate for flexible printed wiring of the present invention.

Fig. 5 is a schematic drawing showing a surface treatment apparatus.

Fig. 6 is a schematic drawing showing a vacuum evaporator. In the drawings, symbols A through D and 1 through 16 mean the following.

A : polyimide film B : first vapor-deposited metal layer C : second vapor-deposited layer D : copper plated layer 1 : long polyimide film 2 : unwinding shaft 3 : hot water drum 4 : winding shaft 5 : heater 6 : glow discharge plasma device 6A : evaporation source 6B : evaporation source 7 : film guide roller 8 : film guide roller 9 : film guide roller 10 : film guide roller 11 : top chamber 12 : bottom chamber 13 : bulkhead 14 : exhaust hole 15 : exhaust hole 16 : gas inlet hole

### The most preferred embodiments of the invention

The base films which can be used for the polyimide film of the present invention include "Kapton" (produced by Toray Du Point and US Du Pont), "Upilex" (produced by Ube Industries), "Apical" (produced by Kanegafuchi Chemical), etc., and these can be effectively used. "Kapton" is available as types H, V, K, E, etc., and among them, especially type E high in Young's modulus and high in mechanical properties, alkali resistance and chemicals resistance is very effective since it is very high in reliability of adhesion after plating, particularly electroless plating.

In the present invention, the tin content of the film is 0.02 to 1 wt%, preferably 0.2 to 0.7 wt% based on the weight of the film. If the tin content is in this range, the vacuum evaporation, plating and surface treatment described later can produce a substrate which is durable in adhesion after such thermal loading, especially stably durable in the adhesion between the copper film and the polyimide film without causing delamination even if it is exposed to a high temperature for a long time. If the tin content is less than 0.02 wt%, the reliability of adhesion is insufficient unpreferably, and if more than 1 wt%, processability declines unpreferably.

The thickness of the polyimide film is preferably 6 µm or more.

If the thickness is less than 6 µm, it is likely to be creased and folded to damage the circuit, unpreferably as a circuit substrate.

To more sufficiently achieve the object of the present invention, it is preferable to use a surface-treated polyimide film or to treat the surface of the polyimide film before vacuum evaporation. Furthermore, if surface treatment is applied, the adhesion is improved to allow the use of a thinner layer as the first vapor-deposited metal layer preferably.

The surface treatment of the polyimide film is applied not only for cleaning but also for improving the adhesion between the polyimide film and the vapor-deposited metal. The intended effect can be highly achieved when the contact angle with water measured by the method described later is in a range of 15 to 35°, preferably 20 to 30°. (The contact angle with water without surface treatment is about 60 to 70°.)

If the surface-treated polyimide film is observed to identify its surface roughness by SEM, it can be estimated that the polyimide film is treated in the surface layer and to a depth of tens of angstroms, or even hundreds of angstroms.

Furthermore, also considering that the film has been cleaned and that functional groups have remarkably increased, it can be stated that the points of contact with the metal to be vapor-deposited increase and that the bonding strength is enhanced. The O/C ratios before and after surface treatment were measured by ESCA, and from their difference, it could be confirmed that a large number of carboxyl groups existed near the surface of the film. If the contact angle is more than 35°, the reliability of adhesion is insufficient unpreferably when the first vapor-deposited layer is thin. If less than 15°, the adhesion fluctuates and becomes insufficient unpreferably. The reason is not identified yet, but it can be considered that the surface treatment is so strong as to cause the film to be deteriorated.

Specific surface treatment means for the film include mechanical treatments such as blasting, hair line treatment and embossing, physicochemical treatments such as corona discharge, plasma treatment and ion gun treatment, chemical solution treatments by use of a solvent, acid or alkali, etc.

Among these means, glow discharge plasma treatment which is a treatment in vacuum is preferable, comprehensively considering the continuity with the subsequent step, productivity, contamination resistance, adhesion, deterioration of film, etc. It is more preferable to apply any other treatment such as corona discharge treatment and to subsequently apply the glow discharge plasma treatment.

The glow discharge plasma treatment can be applied continuously with the subsequent vacuum evaporation while the film travels, or can also be applied independently. For example, a polyimide film once treated by glow discharge plasma can be conveyed in the reverse direction for subsequent vacuum evaporation, or after glow discharge plasma treatment, the polyimide film can be once released from the vacuum system, for subsequent vacuum evaporation. The interval after glow discharge plasma treatment till the evacuation of the subsequent vacuum evaporation is preferably within 15 hours, more preferably within 5 hours in view of holding of adhesion. The plasma power source is preferably direct current, alternating current, high frequency, microwaves, etc., and in view of processability, adhesion, etc., a high frequency is more preferable.

As the plasma electrode, iron, titanium, chromium, aluminum, etc. can be used, and in view of discharge stability, hence adhesion stability, aluminum is preferable.

The distance between the plasma electrode and the film is preferably 20 mm or more, more preferably 30 to 60 mm. If the distance is less than 20 mm, the film travels unstably unpreferably. If more than 60 mm, the treatment effect is weak and adhesion becomes insufficient.

The plasma voltage is preferably 1 to 7 kV, more preferably 3 to 5 kV. If the voltage is less than 1 kV, the adhesion is insufficient unpreferably. If more than 7 kV, the electrode is likely to be damaged due to heat generation, and the film is likely to travel unstably unpreferably.

The area around the plasma electrode becomes hot since the heat generated by the plasma electrode is reserved there.

Therefore, it is preferable to cool the area in view of processability, hence adhesion stability.

The plasma treatment of the present invention is effected for both the purposes of cleaning and achieving better adhesion.

Considering the uniformity in these effects and stability, it is essentially required that the sputtering of the plasma electrode metal resulting in the consumption of the electrode is not caused. The level of the freedom from sputtering must be ensure that in the plasma-treated product of the present invention, the electrode metal is not detected even by XPS which can detect even a monoatomic layer.

If a polyimide film with through holes drilled at predetermined portions according to a conventional method is treated on the surface, the adhesion at the through hole portions is further enhanced preferably.

Removing beforehand the water and gas anticipated to be evolved from the polyimide film in the step of plasma treatment assures stable plasma treatment and stable adhesion preferably.

Removing beforehand the water and gas anticipated to be evolved when the first vapor-deposited metal layer B is formed on the surface-treated film also assures stable vacuum evaporation, and stable adhesion preferably. For this purpose, it is preferable to properly select the heating conditions, vacuum conditions and exhaust conditions.

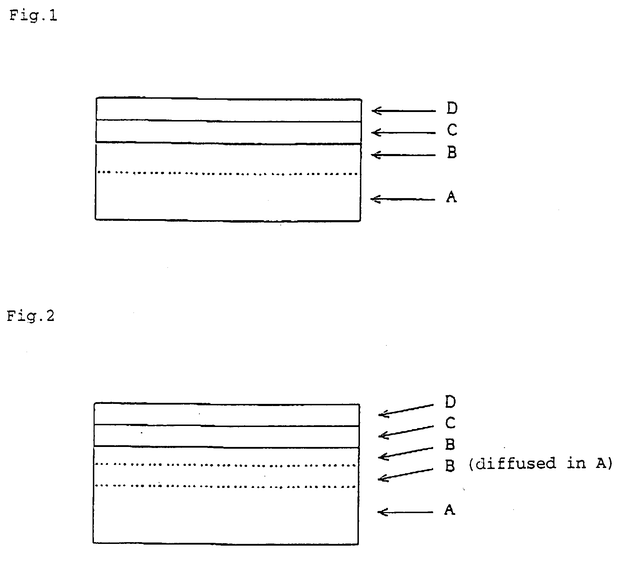

Figs. 1 through 4 are sectional views showing examples of the substrate for flexible printed wiring in the present invention.

Fig. 1 shows a substrate for flexible printed wiring, in which a first vapor-deposited metal B selected from said specific materials with a thickness of 10 to 300 Å formed as a diffusion layer with all the vapor-deposited metal diffused in the polyimide film, a second vapor-deposited copper layer C, and a copper plated layer D are laminated in this order on one side of a polyimide film A containing tin by 0.02 to 1 wt% based on the weight of the film.

Fig. 2 is a substrate for flexible printed wiring similar to that of Fig. 1, but different in the first vapor-deposited metal layer B with some of the vapor-deposited metal diffused in the polyimide film.

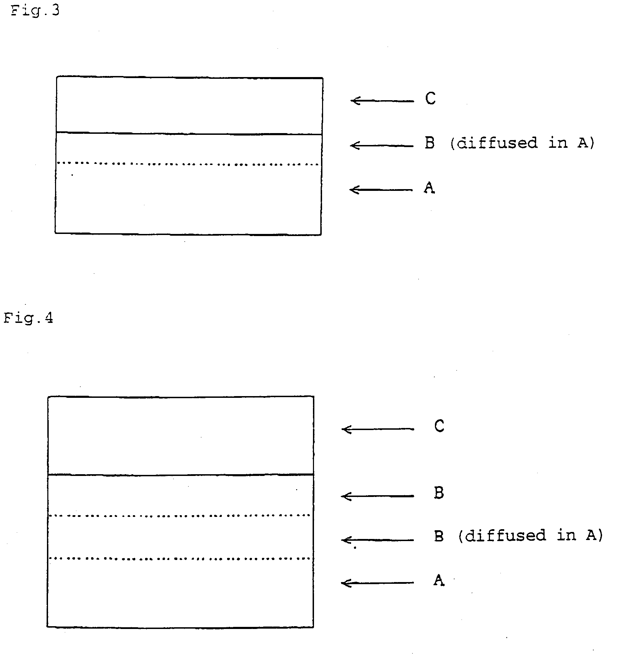

Figs. 3 and 4 show substrates for flexible printed wiring without the copper plated layer D. Fig. 3 shows an embodiment where all the vapor-deposited metal is diffused in the polyimide film, and Fig. 4 shows an embodiment where some of the vapor-deposited metal is diffused in the polyimide film.

In the present invention, the metal constituting the first vapor-deposited metal layer B formed on one side of the illustrated polyimide film 1 must strongly adhere to the polyimide and the second vapor-deposited layer C, must not be diffused by heat, and must be strong and good in chemicals resistance and heat resistance as its important properties.

So, it is preferable to use one or more selected from a group consisting of nickel, chromium, cobalt, palladium, molybdenum, tungsten, titanium and zirconium.

When a circuit is formed on the substrate for flexible printed wiring of the present invention, etching is necessary, and to make the above mentioned properties compatible with the inter-conductor insulation resistance of the formed circuit, it is preferable to etch the first vapor-deposited metal layer B using an etchant different from that for the second vapor-deposited layer C or the copper plated layer D.

The etchant for the second vapor-deposited layer C or the copper plated layer D can be, for example, ferric chloride solution or cupric chloride solution, etc. The first vapor-deposited metal layer B which can make said properties compatible with the inter-conductor insulation resistance of the formed circuit even if said etchant only is used can be made of at least one or more selected from chromium alloys and chromium compounds. Especially nichrome of less than 20% in chromium content or nickel is preferable.

Preferable chromium alloys include those containing aluminum, tin, manganese, iron, nickel, cobalt, tungsten, molybdenum, vanadium, zirconium or silicon, and preferable chromium compounds are chromium oxide and chromium nitride which are insulators. The thickness of the first vapor-deposited metal layer B is 10 to 300 Å, preferably 20 to 50 Å. When the thickness is in this range, the durability of adhesion after thermal loading and the durability after thermal loading subsequent to said plating, particularly electroless plating can be kept. If the thickness is less than 10 Å, adhesion is insufficient, and chemicals resistance and heat resistance are also unsatisfactory unpreferably. On the other hand, if the thickness is more than 300 Å, the vapor-deposited polyimide film is likely to be curled unpreferably in view of stability of processing and efficiency of etching. The thickness of the vapor-deposited layer in this case is measured by observing the cross section by a transmission electron microscope.

The first vapor-deposited metal layer B must be formed on either or both sides of the polyimide film in such a manner that the vapor-deposited metal may be diffused in the depth direction of the film, in order to keep the durability of adhesion after thermal loading and the durability after thermal loading subsequent to said plating, particularly electroless plating. It is necessary that the vapor-deposited metal is diffused to a depth of at least 10 Å or more, preferably 20 Å or more from the surface of the polyimide film.

The reasons are considered to be that the vapor-deposited metal diffused in the polyimide film has an anchoring effect, that the vapor-deposited metal effectively strongly adheres to the tin in the polyimide film, and furthermore that since the vapor-deposited grains are formed deeply at a high energy, the formed vapor-deposited layer is naturally strong.

If a vapor-deposited metal is simply formed on the surface of a polyimide film, the durability of adhesion after thermal loading and the durability after thermal loading subsequent to said plating, particularly electroless plating cannot be kept.

The first vapor-deposited metal layer B is formed on either or both sides of the polyimide film, preferably, by sputtering, ion plating, or ion assisted method. In this case, sputtering is preferable in view of stable processing, simple process, less curling and uniform thickness.

As for the vacuum evaporation conditions of the vapor-deposited layer B, the vacuum degree preset for forming the vapor-deposited film is preferably as high as 5 x 10⁻⁵ torr or less, for keeping the stability of processing.

The gas pressure is preferably a high vacuum of 2 x 10⁻³ torr or less, more preferably 10 x 10⁻⁴ torr or less in view of stable processing and compact layer formation. The gas used can be a noble gas such as argon, neon, krypton or helium, etc. or also nitrogen, hydrogen or oxygen. Among them, argon and nitrogen are preferable since they are inexpensive.

Keeping the potential difference between the evaporation source and the film at 450 V or more at the time of evaporation is preferable for uniformly diffusing the vapor-deposited metal into the polyimide film. The voltage is more preferably 500 V or more. If the voltage is less than 450 V, the vapor-deposited metal cannot be diffused uniformly enough unpreferably.

Keeping the film temperature in a range from 30 to 280°C immediately before vacuum evaporation is preferable in view of more compact and uniform layer formation. A more preferable temperature range is 30 to 120°C. If the temperature is lower than 30°C, the film is insufficiently compact and uniform. If higher than 280°C, blocking occurs after processing due to insufficient cooling, and creases are formed during processing unpreferably. The heating can be effected by using a heated roll or heater immediately before vacuum evaporation. On the first vapor-deposited metal layer B, the second vapor-deposited layer C is formed as shown in Figs. 1 to 4. As the vapor-deposited layer C, copper is vapor-deposited by sputtering, ion plating or electron beam evaporation, etc.

The thickness of the vapor-deposited layer is preferably 100 Å to 5 µm, more preferably 1500 to 5000 Å. If the thickness of the vapor-deposited layer C is less than 100 Å, it cannot sufficiently act as a layer for plating unpreferably. If the thickness is more than 5 µm, no higher effect can be obtained even though the cost is raised unpreferably.

The surface resistance of the second vapor-deposited layer C is preferably 1.0 Ω/ or less, more preferably 0.3 Ω/ or less.

It is preferable in view of excellent productivity to form the second vapor-deposited layer C as shown in Figs. 1 to 4 by ion plating or electron beam evaporation. The grain size of the second vapor-deposited layer C is preferably 0.007 to 0.850 µm.

If the grain size is less than 0.007 µm or more than 0.850 µm, flexibility, extensibility and adhesion reliability become insufficient unpreferably.

Surprisingly, it was found that if the second vapor-deposited copper layer C is formed on the first vapor-deposited metal layer B by the vacuum evaporation method described later, the surface resistance declines, compared with that of the first vapor-deposited metal layer not in conformity with the first vapor-deposited metal layer B of the present invention. This suggests that the copper layer is compact and improved in mechanical properties. This is considered to be a factor to inhibit the cohesive failure caused in a thermal load test, etc. If the second vapor-deposited copper layer is formed on the first vapor-deposited metal layer not in conformity with the first vapor-deposited layer B of the present invention by the vacuum evaporation method described below, a copper layer with a structure relatively more coarse than the second vapor-deposited layer C of the present invention is considered to be formed.

The first vapor-deposited metal layer B and the second vapor-deposited layer C can be formed continuously while the film travels, or discretely. For example, after the first vapor-deposited layer has been formed, the laminated polyimide film can be conveyed in the reverse direction, to have the subsequent second vapor-deposited film C formed, or after the first vapor-deposited metal layer B has been formed, the laminated polyimide film can be once released from the vacuum system, then to have the second vapor-deposited layer C formed. The interval after the first vapor-deposited metal layer B has been formed till the exhaust of the subsequent evaporation is preferably within 3 hours, more preferably within 1.5 hours in view of moisture absorption and the surface oxidation of the vapor-deposited layer. Moisture absorption and the surface oxidation of the vapor-deposited layer are not preferable for keeping the durability of adhesion.

As for the vacuum degree for forming the second vapor-deposited layer C, a high vacuum of 5 x 10⁻⁵ torr or less is kept beforehand and subsequently a high vacuum of 5 x 10⁻⁴ torr or less is kept. Then, while the gas pressure is preferably kept at a high vacuum of 5 x 10⁻³ torr or less, more preferably 5 x 10⁻⁴ torr or less, the vapor-deposited film is formed. The gas used for evaporation can be a noble gas such as argon, neon, krypton or helium, etc. or nitrogen, hydrogen or oxygen.

Among them, argon and nitrogen are preferable since they are inexpensive.

The deposition rate of the second vapor-deposited layer C is preferably 0.5 to 20 m/min, more preferably 1.0 to 10 m/min in view of productivity and less thermal damage to the film. If the deposition rate is lower than 0.5 m/min, productivity is too low unpreferably. On the other hand, if higher than 20 m/min, the vapor-deposited film formed becomes uneven unpreferably.

On the second vapor-deposited layer C, as required, the copper plated layer D is formed by plating as shown in Figs. 1 and 2, to complete a conductor layer. In this case, it is preferable that the copper plated layer D is controlled in surface roughness to keep the protruded portions at heights of 0.5 µm and less and the depressed portions at depths of 0.3 µm and less. If the heights of the protruded portions exceed 0.5 µm or if the depths of the depressed portions exceed 0.3 µm, the accuracy after formation of resist coating is too low and it is difficult to form a highly reliable circuit. It is more preferable that the heights of the protruded portions are 0.4 µm or less and that the depths of the depressed portions are 0.2 µm or less. Preferable plating methods are electroplating, electroless plating, etc.

It is preferable that the thickness of the copper plated layer D is in a range from 1 to 18 µm. If the thickness is less than 1 µm, respective kinds of the performance with the circuit formed decline. If more than 18 µm, the accuracy of line widths in a high density circuit declines, and the reduction in weight and size with parts mounted is adversely affected.

It is also unpreferable in view of cost rise.

The substrate for flexible printed wiring of the present invention formed as a multi-layer vapor-deposited film or as a multi-layer vapor-deposited film with a plated layer has excellent durability of adhesion not only in the thermal load test after circuit formation, but also in the thermal load test after plating, particularly electroless plating subsequent to circuit formation. The reasons why such an effect can be achieved are not clear enough, but can be considered as described below. Firstly, the polyimide film is a high strength film obtained by more intensively crosslinking polyimide molecules through tin. Secondly, the first vapor-deposited metal layer is compact and uniform with its specific metal diffused in the polyimide film. In addition, since the first vapor-deposited metal layer contains a metal mixture layer with the vapor-deposited metal diffused in the tin-containing polyimide, the first vapor-deposited metal layer is formed as a more highly compact and stable layer. Thirdly, the second vapor-deposited layer formed on the first vapor-deposited metal layer is compact and uniform. Fourthly, the plated copper layer formed on the second vapor-deposited layer is compact and uniform. These layers are considered to form a compact and uniform structure with less faults, thus enhancing heat resistance and chemicals resistance. Fifthly, the bonding strength between the polyimide film and the first vapor-deposited metal layer is enhanced, and especially the heat resistance and chemicals resistance of the bonding are enhanced. Sixthly, especially the barrierability of the first vapor-deposited metal layer against the oxidizing and deteriorating factors acceleratedly migrating from the polyimide film for diffusion into the copper layer during the thermal load test is enhanced.

Since the substrate for flexible printed wiring of the present invention has excellent performance in various thermal load tests, a highly accurate circuit can be formed.

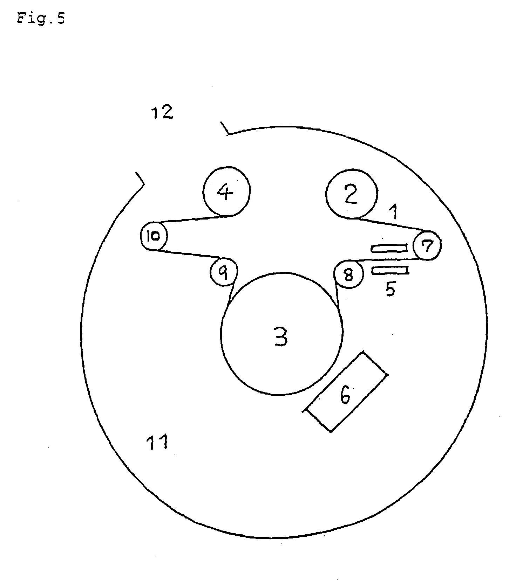

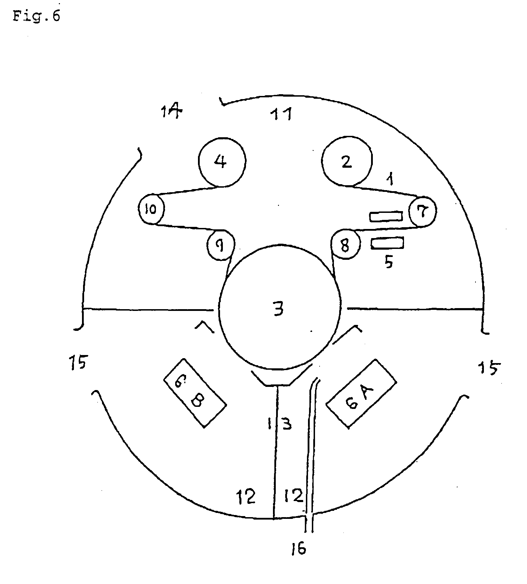

One of the methods for producing the substrate for flexible printed wiring of the present invention is described below in reference to Figs. 5 and 6. Fig. 5 is a schematic drawing showing a surface treatment apparatus loaded with a long polyimide film 1. In a vacuum tank 11, a traveling system consisting of an unwinding shaft 2, a cylindrical hot water drum 3 and a winding shaft 4 is installed, and in addition, a heater 5 for pre-heating the film, a glow discharge plasma device 6 with a gas inlet hole and film guide rollers 7, 8, 9 and 10 are installed.

In the surface treatment apparatus of Fig. 5, the polyimide film 1 is unwound from the unwinding shaft 2 at a constant unwinding tension at a speed of 0.5 to 20 m/min, and heated by the infrared heater 5 in a range between the rollers 7 and 8.

Then, it is guided around the roller 8 and while it is kept in contact with the cylindrical hot water drum 3, it is treated on the surface by the glow discharge plasma treatment device 6 using argon gas. The plasma treatment device contains a pair of electrodes; an electrode capable of applying a high voltage and an earthed electrode. It can treat at an argon gas pressure of 0.001 to 1 torr at a high frequency of 50 kHs to 500 MHz. Subsequently, it is guided around the rollers 9 and 10 and wound by a winding core installed in the winding shaft 4 at a constant winding tension.

Fig. 6 is a schematic drawing showing a vacuum evaporator loaded with a long polyimide film 1. In the vacuum tank, a traveling system consisting of an unwinding shaft 2, a cylindrical hot water drum 3 and a winding shaft 4 is installed, and in addition, a heater 5 for pre-heating the film and film guide rollers 7, 8, 9 and 10 are installed in a top chamber 11, while a plurality of evaporation sources 6A and 6B and a gas inlet hole 16 are provided in a bottom chamber 12. Furthermore, a bulkhead 13 is installed for separating the bottom chamber 12, and exhaust holes 14 and 15 are provided for evacuation.

In the vacuum evaporator of Fig. 6, the polyimide film 1 is unwound from the unwinding shaft 2 at a constant unwinding tension at a speed of 0.5 to 20 m/min, and heated by the infrared heater 5 in a range between the rollers 7 and 8.

Then, it is guided around the roller 8 and while it is kept in contact with the cylindrical hot water drum 3, it has a first vapor-deposited layer laminated using the evaporation source 6A by glow discharge sputtering of argon gas and subsequently has a second vapor-deposited layer laminated using the evaporation source 6B similarly.

For evaporation, at first, the pressure in the bottom chamber 12 is reduced beforehand to 5 x 10⁻⁵ torr or less by evacuation, and argon gas is introduced for evaporation at a gas pressure of 5 x 10⁻³ torr or less. The first vapor-deposited metal layer is formed with a chromium target as the evaporation source 6A, to have a thickness of 10 to 300 Å, and the second vapor-deposited layer is formed with a copper target as the evaporation source 6B, to have a thickness of 100 Å to 5 µm, respectively by magnetron sputtering. For the first vapor-deposited metal layer, any desired gas can be introduced using the gas inlet hole 16 which can control a slight amount. In succession, the film is guided around the rollers 9 and 10 and wound around a winding core installed in the winding shaft 4 at a constant winding tension. The processed film is a wide and long roll of a substrate for flexible printed wiring of the present invention.

Furthermore, though not illustrated, the processed film can have a copper layer further laminated by electroplating according to the roll-to-roll method using a copper sulfate aqueous solution, to produce a wide and long roll of a substrate for flexible printed wiring of the present invention.

### Examples

The present invention is described below in detail in reference to examples, but is not limited thereto or thereby.

The respective properties in this specification and in the following examples were measured according to the following methods.

### (1) Contact angle of polyimide film

A FACE contact angle meter produced by Kyowa Kaimen Kagaku K.K. was used for obtaining the contact angle according to the liquid drop method.

### (2) Surface resistance

MCP-TESTER LORESTA-FP produced by Mitsubishi Petrochemical Co., Ltd. was used for measuring with two probes.

### (3) Vapor-deposited grain size

A scanning electron microscope was used to measure the vapor-deposited grain size on the surface of a vapor-deposited layer at 50,000 times. When the grains are asymmetric in form, the major axes were measured.

### (4) Thickness of vapor-deposited layer

A tracer type surface roughness tester was used for evaluation. A sample was prepared by partially coating the base with a removable ink before vacuum evaporation, forming a vapor-deposited film on it, and removing the vapor-deposited film together with the ink coating.

### (5) Delamination strength

The adhesive strength was obtained according to JIS C 6481 (peeling at 180°).

### Example 1

A 50 µm thick polyimide film "Kapton E" (produced by Toray Du Pont) containing 0.35 wt% of tin was treated by glow discharge plasma at an argon gas pressure of 0.03 torr, using a high frequency power source at a rate of 3 m/min. The contact angle with water of the treated film was 30°. Then, in a tank evacuated to 3 x 10⁻⁵ torr beforehand, chromium was vapor-deposited on the film at a sputtering voltage of 480 V, to have a thickness of 30 Å, and copper was vapor-deposited on the chromium layer, to have a thickness of 1500 Å, respectively by DC magnetron sputtering. The vapor-deposited film was immediately electroplated in a copper sulfate bath at a current density of 2 A/dm², to have an 8 µm thick copper plated layer with a surface roughness of 0.4 µm or less in the heights of the protruded portions on the surface and 0.2 µm or less in the depths of the depressed portions, for forming a substrate for flexible printed wiring of the present invention.

### Example 2

A substrate for flexible printed wiring of the present invention was obtained by the same processing as described in Example 1, except that glow discharge plasma treatment was not effected. The thickness of the chromium layer was 30 Å.

### Example 3

A substrate for flexible printed wiring of the present invention was obtained by the same processing as described in Example 1, except that a 280 Å thick chromium layer was formed by adjusting the vacuum evaporation time.

### Example 4

A substrate for flexible printed wiring of the present invention was obtained by the same processing as described in Example 1, except that nickel was used instead of chromium to form a 40 Å thick vapor-deposited layer at a sputtering voltage of 500 V.

### Comparative example 1

A substrate for flexible printed wiring not in conformity with the present invention was obtained by the same processing as described in Example 1, except that "Kapton E" film not containing tin was used and that chromium was vapor-deposited at a sputtering voltage of 400 V. The thickness of the chromium layer was 30 Å.

### Comparative example 2

A substrate for flexible printed wiring not in conformity with the present invention was obtained by the same processing as described in Example 1, except that chromium was vapor-deposited to have a thickness of 320 Å by adjusting the vacuum evaporation time.

〈 Measurement of thicknesses of chromium layer and nickel layer 〉 : The chromium and nickel sputtered layers of the respective examples and comparative examples were sampled, and their thicknesses were measured on sectional photos taken using a transmission electron microscope.

The respective substrates for flexible printed wiring obtained in Examples 1 to 4 and Comparative Examples 1 and 2 were evaluated according to the following two evaluations methods 1 and 2.
Evaluation 1 : On the copper layer of the substrate for flexible printed wiring obtained in each of Examples 1 to 4 and Comparative Examples 1 and 2, a resist was screen-printed, and the copper layer and the chromium-copper layer were etched by ferric chloride in the portions free from the resist, to form a circuit. The substrate for flexible printed wiring of Comparative Example 2 not in conformity with the present invention was poor in processability.
Evaluation 2 : On the copper layer of the substrate for flexible printed wiring obtained in each of Examples 1 to 4 and Comparative Example 1, a resist was screen-printed, and the copper layer and the chromium-copper layer were etched by ferric chloride in the portions free from the resist, to form a circuit. The obtained flexible printed circuit board was allowed to stand in a 150°C oven for 10 days for a thermal load test. Separately, the obtained flexible printed circuit board was treated in an electroless tin plating solution called Tinposit LT-34 (produced by SHPLEY) at 70°C for 5 minutes, to have a 0.5 µm thick plated layer, and the plated board was subjected to a thermal load test similar to the above. The adhesive strengths of the respective flexible printed circuit boards were measured after the respective thermal load tests, and the results are shown in Table 1. It can be seen that Examples 1 to 4 in conformity with the present invention are more excellent in the thermal load resistance after circuit formation and also in the thermal load resistance after the electroless plating subsequent to circuit formation than Comparative Examples 1 and 2, and hence that highly reliable flexible printed circuit boards can be obtained according to the present invention. It can also be seen that a more excellent effect can be achieved if the polyimide film is plasma-treated on the surface.

**Table 1**

| Example | Adhesive strength(g/cm) | | Judgment |
|---|---|---|---|
| | After thermal loading subsequent to circuit subsequent formation | After thermal loading to tin plating | |
| Example 1 | 230 | 200 | Good |
| Example 2 | 130 | 100 | Rather good |
| Example 3 | 300 | 270 | Good |
| Example 4 | 210 | 180 | Good |
| Comparative example 1 | 30 | 10 | Poor |

## Claims

1. A substrate for flexible printed wiring, comprising a polyimide film containing tin by 0.02 to 1 wt% based on the weight of the film; a vapor-deposited metal, being partially or wholly diffused in the depth direction from the surface of the film; a first vapor-deposited metal layer with a thickness of 10 to 300 Å including said diffusion layer, being provided on either or both sides of the film; and a second vapor-deposited copper layer on said first vapor-deposited layer.

2. A substrate for flexible printed wiring, according to Claim 1, wherein a copper plated layer is formed further on the second vapor-deposited layer.

3. A substrate for flexible printed wiring, according to Claim 1 or 2, wherein the metal of the first vapor-deposited metal layer is any one or more selected from a group consisting of chromium, chromium alloys and chromium compounds.

4. A substrate for flexible printed wiring, according to Claim 1 or 2, wherein the metal of the first vapor-deposited metal layer is nichrome of less than 20% in chromium content.

5. A substrate for flexible printed wiring, according to Claim 1 or 2, wherein the metal of the first vapor-deposited metal layer is nickel.

6. A substrate for flexible printed wiring, according to any one of Claims 1 through 5, wherein the polyimide has through holes drilled.

7. A substrate for flexible printed wiring, according to any one of Claims 1 through 6, wherein the polyimide film has a contact angle with water of 15 to 35°.
